(19) Europäisches Patentamt

European Patent Office

Office européen des brevets

(11) Veröffentlichungsnummer: **0 216 001**

**A1**

(12) # EUROPÄISCHE PATENTANMELDUNG

(21) Anmeldenummer: 86102863.7

(51) Int. Cl.⁴: **G01R 31/06 , G01R 31/12**

(22) Anmeldetag: 05.03.86

(30) Priorität: 26.08.85 DD 279970

(43) Veröffentlichungstag der Anmeldung:
01.04.87 Patentblatt 87/14

(84) Benannte Vertragsstaaten:
AT BE CH DE FR GB IT LI SE

(71) Anmelder: VEB Transformatorenwerk "Karl Liebknecht"
Wilhelminenhofstrasse 83-85
DDR-1160 Berlin(DD)

(72) Erfinder: Atzenroth, Dietrich
Pablo-Neruda-Strasse 22
DDR-1170 Berlin(DD)
Erfinder: Christ, Joachim
Lauterbachstrasse 4
DDR-1100 Berlin(DD)
Erfinder: Eick, Werner
Döbrabergweg 4
DDR-1110 Berlin(DD)
Erfinder: Hoppadietz, Frieder, Dr.-Ing.
Lindhorstweg 87
DDR-1197 Berlin(DD)
Erfinder: Weser, Manfred, Dipl.-Ing.
Am Wildgarten 37
DDR-1613 Wildau 37(DD)

(74) Vertreter: Patentanwälte Beetz sen. - Beetz jun. Timpe - Siegfried - Schmitt-Fumian
Steinsdorfstrasse 10
D-8000 München 22(DE)

(54) **Verfahren zur Prüfung von Primärwicklungen induktiver Spannungswandler.**

(57) Die Erfindung bezieht sich auf ein Verfahren zur Prüfung von Primärwicklung von induktiven Spannungswandlern auf latente Fehlerstellen, insbesondere Windungs- und Lagenschluß. Das Prinzip dieses Prüfverfahrens besteht darin, in geeigneter Weise verdeckte Fehlerstellen in Primärwicklungen induktiver Spannungswandler, die aus vielen Windungen dünnen Drahtes bestehen, so zu aktivieren, daß sie mit herkömmlichen Meßmitteln ohne besonderen Prüfaufbau festgestellt werden können. Das wird dadurch erreicht, daß die bereits im Gerät eingebaute Primärwicklung kurzgeschlossen und durch Erregung einer anderen Wicklung mit Wechselspannung aufgeheizt und auf einen Temperatur gebracht wird, die innerhalb der zulässigen Betriebstemperatur liegt. Anschließend wird die Primärwicklung mit relativ hohen Gleichströmen in Intervallen so erwärmt, daß der Temperaturanstieg im geradlinigen Anstieg der Erwärmungskurve liegt. Unmittelbar nach Erreichen der Prüftemperatur wird eine Dauerwechselspannung angelegt, wo-bei während dieser Belastung durch Zu- und Abschalten von Impedanzen im Erregerkreis Oberspannungen erzeugt werden.

## Verfahren zur Prüfung von Primärwicklungen inducktiver Spannungswandler

Die Erfindung bezieht sich auf ein Verfahren zur Prüfung von Primärwicklungen induktiver Spannungswandler auf latente Fehlerstellen.

Neben den üblichen, durch internationale und nationale Standards vorgeschriebenen Prüfungen von induktiven Spannungswandlern mit Wechsel-, Schalt-und Blitzspannung sowie die Messung des Verlustfaktors tan $\int$ und der Teilentladungen ist die Kontrolle der mit relativ hoher Windungszahl und kleinem Leiterquerschnitt hergestellten Primärwicklung auf latente Fehlerstellen, insbesondere auf Windungs-und Lagenschluß, von besonderer Bedeutung.

Es sind bereits herstellungs-und gerätebezogene Verfahren und Anordnungen zur Fehlerbeurteilung bekannt. So findet zum Beispiel bei Teilentladungsmessungen das Differenzverfahren Anwendung, bei dem ein für diesen speziellen Fall fehlerfrei präpariertes Gerät mit dem zu prüfenden Gerät verglichen wird.

Eine weitere Möglichkeit der Fehlererkennung besteht in der Anwendung eines E.R.A.-Entlade-Detektors, der die charakteristischen Erscheinungsformen von Fehlern an den einzelnen Wicklungen katalogisiert, sie mit bereits geprüften Wicklungen vergleicht und so einen bildhaften Vergleich in Form eines Fehleratlasses ermöglicht. In der DE-B 1041154 ist ein Verfahren zur Prüfung von Spulen auf Windungsschluß beschrieben, bei dem die zu prüfende Spule über ein offenes Joch mit einer tonfrequent gespeisten Schwingkreisspule magnetisch gekoppelt wird. Dieses sowie die vorgenannten Verfahren eignen sich jedoch nur für Spulen mit kleiner Windungszahl und größerem Leiterquerschnitt sowie für Spulen mit geringer Spannungsfestigkeit. Weiter ist der DE-B 1178938 als technische Information zu entnehmen, daß mit Hilfe einer Einrichtung elektrische Spulen bei betriebsmäßiger Belastung durch Ermitteln des Verhältnisses von Spulenspannung zu Spulenstrom auf Windungsschluß geprüft werden können. Dabei geht man von der Voraussetzung aus, daß erst bei Belastung mit normaler Stromstärke Windungsschlüsse von Spulen in Erscheinung treten.

Die Praxis hat jedoch gezeigt, daß die Prüfung unter normalen betriebsmäßigen Belastungen allein nicht ausreicht, um latente Fehlerstellen in der Primärwicklung eines induktiven Spannungswandlers aufzudecken. Die Primärwicklung eines solchen Wandlers mit einer Eingangsspannung > 10 kV stellt gegenüber anderen elektrischen Wicklungen ein elektrisch und geometrisch sehr kompaktes Gebilde dar. Dadurch wird die Ermittlung einer kurzgeschlossenenWindung sowohl bei einem Verhältnis von 1 : 30 000, bezogen auf die Gesamtwindungszahl, als auch über den Anteil an der Streuung einer Windung mit einem Drahtdurchmesser von 0,15 bis 0,24 mm in einem Gesamtwicklungsquerschnitt von ca. 10 000 mm², was etwa einem Verhältnis von 1 : 350 000 entspricht, sehr erschwert. Aus den aufgezeigten Gründen sind alle direkten Meßverfahren, wie Leistungsmessung, Widerstandsmessung R und Z, Fehlermessung, Resonanzverfahren usw., nicht anwendbar bzw. nicht ausreichend, um verdeckte Fehlerquellen, insbesondere Windungsschlüsse in Primärwicklungen induktiver Spannungswandler, sicher auszuweisen. Der normale Betriebszustand mit einer möglichen Erwärmung ergibt nur eine unzureichende statische Beanspruchung durch Druck und elektrische Spannung.

Der Erfindung liegt die Aufgabe zugrunde, ein Verfahren zur Prüfung von Primärwicklungen induktiver Spannungswandler auf latente Fehlerstellen und insbesondere zum Erkennen von latenten Windungs-und Lagenschlüssen, besonders für Primärwicklungen induktiver Spannungswandler, die aus vielen Windungen dünnen Drahtes bestehen, anzugeben.

Die Aufgabe wird anspruchsgemäß gelöst.

Das erfindungsgemäße Prüfverfahren beruht auf der allgemeinen Konzeption, verdeckte Fehlerstellen in Primärwicklungen induktiver Spannungswandler so zu aktivieren, daß sie ohne besonderen Prüfaufbau mit herkömmlichen Mitteln festgestellt werden können. Das wird erfindungsgemäß dadurch erreicht, daß die bereits im Gerät eingebaute Primärwicklung kurzgeschlossen und durch Erregung einer anderen Wicklung mit Wechselspannung aufgeheizt und auf eine Temperatur gebracht wird, die innerhalb der zulässigen Betriebstemperatur liegt. Anschließend wird die Primärwicklung mit relativ hohen Gleichstromwerten oder einem Strom mit einer Frequenz < 50 Hz mit Stromdichten, die mindestens eine Zehnerpotenz über den jeweils betriebsmäßig zulässigen Stromdichten liegen, bis zur Erreichung der für den verwen deten Wickeldraht zulässigen Temperatur in Intervallen so erwärmt, daß der Temperaturanstieg nahezu im geradlinigen Anstieg der Erwärmungskurve liegt. Hierbei werden die Intervalle so gesteuert, daß es nicht zu einer Abkühlung der Primärwicklung kommt, sondern das erreichte Temperaturniveau gehalten werden kann, um einen Ausgleich etwaiger Temperaturdifferenzen innerhalb der Primärwicklung zu erzielen. Der dabei auftretende Lebensdauerverlust, der charakterisiert ist durch das Temperatur-Zeitintegral über die gesamte Prüfperiode, einschließlich Erwärmung und Abkühlung, ist gegenüber der Gesamtlebensdauer der Isolierung sehr klein. Unmittelbar nach Erreichen der Prüftemperatur wird dann eine Dauerwechselspannung angelegt, und es werden durch Zu-und Abschalten von Impedanzen im Erregerkreis Überspannungen erzeugt, deren Verhältnis zur Dauerwechselspannung durch eine veränderliche Impedanz einstellbar ist. Das erfindungsgemäße Prüfverfahren ermöglicht den Einsatz von herkömmlichen Detektoren, die jederzeit Auskunft über das Isolationsverhalten der Primärwicklung geben können, z.B. dadurch, daß durch die Erwärmung innerhalb der Wicklung Gasblasen infolge ·von Strömungsvorgängen in das Randfeld gelangen, wo sie meßbare Teilentladungen oder Durchschläge erzeugen.

Die durch die Erfindung erreichten Vorteile sind im wesentlichen darin zu sehen, daß latente Windungs-und Lagenschlüsse in Primärwicklungen induktiver Spannungswandler sicher erkannt und somit ein späterer Ausfall des Gerätes im Netzbetrieb und der damit verbundene Folgeschaden für das betreffende Netz einschließlich der darin eingebundenen anderen Geräte vermieden werden. Die Zuverlässigkeit der erfolgreich erfindungsgemäß geprüften Spannungswandler erreicht einen sehr hohen Grad.

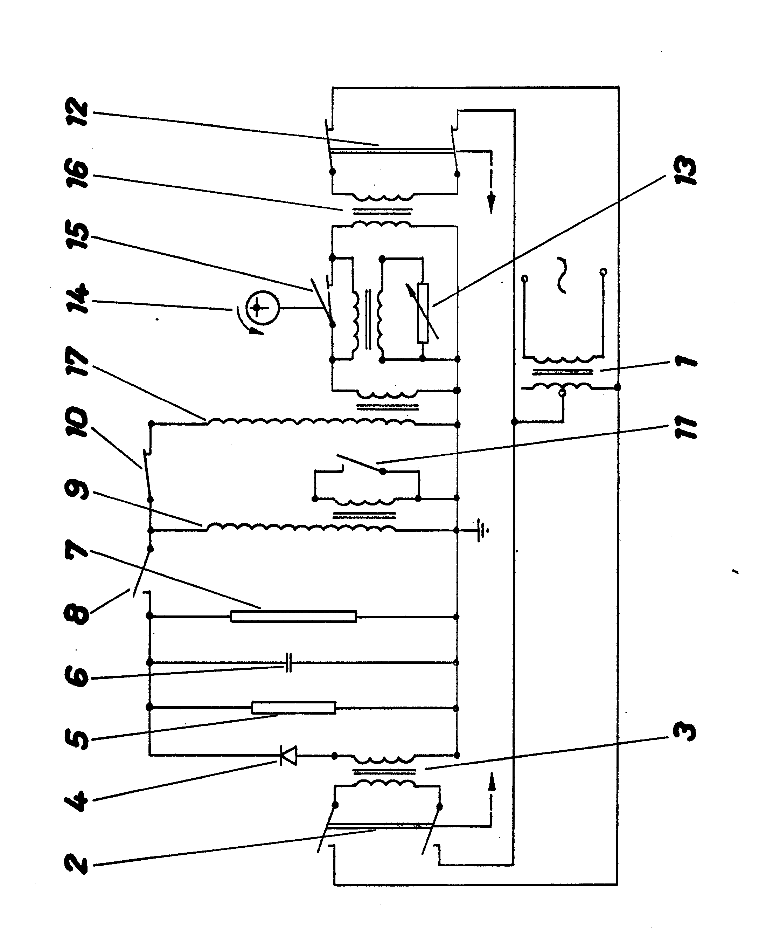

Im folgenden wird die Erfindung anhand der Zeichnung näher erläutert, in der eine beispielhafte Ausführungsform dargestellt ist. Die Zeichnung zeigt einen Prüfschaltungsaufbau zur Durchführung des Prüfverfahrens, bei dem die Primärwicklung des induktiven Spannungswandlers 9 sekundär mit dem Schalter .11 kurzgeschlossen ist und bei geschlossenem Schalter 12 über die Transformatoren 1 und 16 der Hochspannungstransformator 17 erregt wird. Durch die Steuereinrichtung 14 wird hierbei der Schalter 15 geschlossen gehalten, und der Trenner 10 ist ebenfalls geschlossen, der Trenner 8 geöffnet. Mit den Transformatoren 1 und 16 wird der für die Aufheizung des Spannungswandlers 9 erforderliche Strom eingestellt. Nachdem die erforderliche Temperatur in der Primärwicklung des Spannungswandlers 9 erreicht ist, wird der Transformator 1 auf Null gestellt und der Trenner 10 geöffnet, wonach der Schalter 12 öffnet und der Schalter 2 gleichzeitig schließt. Nach Öffnung des Schalters 11 und Schließen des Trenners 9 sind damit die Voraussetzungen für die Aufheizung der Primärwicklung des Spannungswandlers 9 mit Gleichstrom gegeben. Der von den Transformatoren 1 und 3 ausgehende Strom wird mit dem Gleichrichter 4 gleichgerichtet und über den Trenner 8 der Primärwicklung des Spannungswandlers 9 zugeführt. In dieser Schaltung erfolgt durch Einstellung des Transformators 1 die Aufheizung der Primärwicklung in mehreren Zeitintervallen, bis die erforderliche Prüftemperatur erreicht ist. Hierbei ist der Widerstand 5 als Entlade widerstand für den Glättungskondensator 6 wirksam,und der Spannungsteiler 7 dient zur Messung der Gleichspannung. Nach Stellen des Transformators 1 auf Null erfolgt durch Öffnen des Trenners 8 und des Schalters 2 sowie Schließen des Trenners 10 und des Schalters 12 die Umschaltung zur Durchführung der Prüfung des Spannungswandlers 9 auf Windungs-bzw. Lagenschluß bei erwärmter Primärwicklung. Mit den Transformatoren 1 und 16 wird die gewählte Oberspannung für den Spannungswandler 9 eingestellt, wobei der Schalter 15 über die Steuereinrichtung 14 geschlossen ist. Bei gleicher Einstellung der Transformatoren 1 und 16 und geöffnetem Schalter 15 wird mit dem einstellbaren Widerstand 13 die Prüfspannung eingestellt. Um am Spannungswandler 9 Überspannungen zu erzeugen, wird innerhalb des Prüfablaufs der Schalter 15 durch die Steuereinrichtung 14 mehrmals betätigt. Gleichzeitig kommt es zu Einschwingvorgängen des Erregerstromes, die bewirken, daß die Normalwerte um ein Vielfaches überschritten werden, und die Primärwicklung des Spannungswandlers gleichzeitig einer mehrfachen Prüfbeanspruchung ausgesetzt wird. So werden die einzelnen Windungen und ihre Isolierung durch Temperatur, Spannungen und eletromechanische Kräfte beansprucht. Diese Kombinationsbeanspruchung ist eine wesentliche Voraussetzung für die Aktivierung latenter Defektstellen.

## Ansprüche

Verfahren zur Prüfung von Primärwicklungen induktiver Spannungswandler auf latente Fehlerstellen, **dadurch gekennzeichnet,** daß

-die bereits im Gerät eingebaute Primärwicklung kurzgeschlossen und durch Erregung einer anderen Wicklung mit Wechselspannung aufgeheizt und auf eine Temperatur gebracht wird, die innerhalb der zulässigen Betriebstemperatur liegt,

-danach die Primärwicklung mit relativ hohen Gleichströmen oder Wechselströmen einer Frequenz < 50 Hz bis zur Erreichung der für den verwendeten Wickeldraht zulässigen Temperatur in Intervallen so erwärmt wird, daß der Temperaturanstieg nahezu im geradlinigen Anstieg der Erwärmungskurve liegt,

-unmittelbar nach Erreichen der Prüftemperatur eine Dauerwechselspannung angelegt wird,

und

-während der Belastung der Primärwicklung mit Dauerwechselspannung durch Zu-und Abschalten von Impedanzen im Erregerkreis Überspannungen erzeugt werden.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| A | TECHNISCHE MITTEILUNGEN AEG-TELEFUNKEN, Band 62, Nr. 7, 1972; Seiten 306-308, D. DOBSCHALL "Kurzschlussstrom-Prüfung an Giessharz-Stromwandlern" * Seiten 306-308 * | 1 | G 01 R 31/06 G 01 R 31/12 |
| | --- | | |
| A | CA-A-1 191 719 (J.P. CHOMICZ) * Anspruch 1 * | | |
| | --- | | |
| D,A | DE-B-1 178 938 (H. LANGKAU) * Spalte 1, Zeile 1 - Spalte 4, Zeile 2 * | | |
| | --- | | |
| A | DE-C-1 041 154 (E. BARTELS) * Anspruch 1; & DE - B - 1 041 154 (Kat. D,A) * | | RECHERCHIERTE SACHGEBIETE (Int. Cl.4) |
| | ----- | | G 01 R 31/06 G 01 R 31/12 |

Der vorliegende Recherchenbericht wurde für alle Patentansprüche erstellt.

| Recherchenort | Abschlußdatum der Recherche | Prüfer |
|---|---|---|
| BERLIN | 28-11-1986 | LEMMERICH J |

EPA Form 1503 03 82

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument